# EUROPEAN PATENT APPLICATION

(11) **EP 3 352 178 A1**
(43) Date of publication of application: **25.07.2018**
(21) Application number: 16846390.9
(22) Date of filing: 09.09.2016
(51) Int. Cl.: H01B 7/10, H05K 1/02, H05K 1/03

(54) **ELASTIC WIRING MEMBER**

(30) Priority: 17.09.2015 JP 2015184102
(71) Applicant: SEKISUI POLYMATECH CO., LTD., Saitama 3380837 (JP)
(72) Inventor: KIKUCHI, Kozue, Saitama-city Saitama 338-0837 (JP)
(74) Representative: Schmid, Wolfgang
(86) International application number: PCT/JP2016/076642
(87) International publication number: WO 2017/047519

(57) **Abstract**

To provide an elastic wiring member that is to be used in connection with an electronic component or an external electronic device and that is less likely to undergo a change in resistance when the member is stretched. An elastic wiring member 11 includes a stretchable wiring line 13 having stretchability and connected to a contact 16 of an electronic device main body A and a contact 17 of an electronic component, and a base sheet 12, formed of a rubber-like elastic body, holding the stretchable wiring line 13. The elastic wiring member 11 further includes reinforcing members 14 arranged in or on the base sheet 12. The reinforcing members 14 are located adjacent to connection parts 13b of the stretchable wiring line 13 connected to the contacts 16 and 17 when the base sheet 12 is viewed from above. The reinforcing members 14 inhibit the base sheet 12 from stretching and prevent deformation of the connection parts 13b of the stretchable wiring line 13.

## Description

### Technical Field

The present invention relates to a stretchable elastic wiring member including a conductive wiring line.

### Background Art

A bendable flexible substrate having flexibility is used to mount an electronic component on an electronic device. Such a substrate is bendable but it is not stretchable when pulled. The substrate has no stretchability. Japanese Unexamined Patent Application Publication No. 2007-173226 (PTL 1) discloses an example of an electronic component fixed to a stretchable rubber-like elastic body. According to a technique disclosed in Japanese Unexamined Patent Application Publication No. 2007-173226, a conductor formed by bringing conductive particles into contact with one another is disposed on a stretchable rubber-based base, thus forming a member that is stretchable as a whole.

### Citation List

### Patent Literature

PTL 1: Japanese Unexamined Patent Application Publication No. 2007-173226

### Summary of Invention

### Technical Problem

However, the use of such a stretchable member leads to unstable connection with an electronic component. Stretching of the member causes an increase in resistance in the member, and the degree of increase in resistance fluctuates in a wide range. Furthermore, repeated use of the member may cause a phenomenon in which a resistance remains increased.

A flexible substrate, which is a member disposed in an electronic device for stationary use, is not essentially required to have stretchability. However, an electronic device for use in applications involving deformation or movement, such as a wearable device and a robot, is required to be connected to a stretchable member, such as a band.

The present invention aims to provide an elastic wiring member that has stretchability and that is less likely to undergo a change in resistance when stretched.

### Solution to Problem

To achieve the above-described aim, the present invention provides an elastic wiring member configured as follows.

Specifically, the elastic wiring member includes an elastic sheet formed of a rubber-like elastic body, a stretchable wiring line including a conductive line disposed inside the elastic sheet and connection part located on the conductive line, and a reinforcing member disposed adjacent to the connection part and made of a rigid material. The reinforcing member inhibits the elastic sheet from stretching and contracting, or deforming around the connection part.

According to the present invention, the stretchable wiring line disposed in the elastic sheet enables the elastic wiring member to be stretchable as a whole. Thus, the elastic wiring member can be used not only as a bendable member, such as a flexible substrate, but also as a stretchable member, which a flexible substrate fails to serve as. The elastic wiring member can be used as a movable member that includes a stretchable wiring line and that is required to stretch and bend, for example, a band of a wearable device or a joint of a robot.

The elastic wiring member includes the reinforcing member disposed adjacent to the connection part and made of the rigid material. The reinforcing member inhibits the elastic sheet from stretching and contracting, or deforming around the connection part. Therefore, when the elastic sheet is stretched and contracted, deformation of the elastic sheet around the connection part of the stretchable wiring line is reduced or eliminated, thus reducing or eliminating elastic deformation of the connection part. This can prevent a connection target member in electrical communication contact with the connection part from being separated from the connection part and also prevent poor electrical communication, which is caused by a change in resistance due to stretching of the connection part. Advantageously, the elastic wiring member that enables stable transmission of electrical signals can be achieved.

The elastic wiring member may include a connection target member in electrical communication with the stretchable wiring line through the connection part. The connection target member in electrical communication through the contact part enables the elastic wiring member to have various functions or to be connected to an external electronic device.

The stretchable wiring line may include a plurality of connection parts. Since the connection parts are arranged at different positions in an electrical communication path of the stretchable wiring line, the connection target member can be electrically connected to the connection parts at different positions in the elastic sheet. Furthermore, different connection target members can be connected to the respective connection parts.

The connection target member may be at least one of an electronic device, an electronic component, and a contact member. Examples of the electronic device include an "electronic device main body", such as a main body of a wearable device, and an "external electronic device" to be externally attached to an outer surface of the elastic sheet. Examples of the "electronic device main body" include a watch main body and a heart rate meter. Examples of the "external electronic device" include a charger for charging, for example, an electronic component included in the elastic wiring member, and a cable for data transmission.

The connection target member may be an electronic component. Examples of the electronic component include a sensor component, a lighting component, and an image display component. Various functions achieved by these electronic components can be implemented in the elastic sheet.

The connection target member may be a contact member. Examples of the contact member include a piece of metal and a conductive printed layer. The contact member can be used to achieve electrical connection to an external electronic device.

The connection target member may be fixed to the connection part. In such a configuration, in which the connection target member is fixed to the connection part, the reinforcing member can maintain such a fixed state. A conductive fixing element can be disposed between the connection target member and the connection part. Concrete examples of the fixing element include a conductive adhesive, a metal layer for soldering, and a carbon printed layer.

The connection target member may be disposed inside the elastic sheet. Such a configuration enables the elastic sheet to protect the connection target member disposed in the elastic sheet. In this case, the connection target member may be disposed in any of the following states: the connection target member as a whole is disposed inside the elastic sheet; the connection target member as a whole is disposed inside the elastic sheet having a window and is partly exposed through the window; and the connection target member is partially disposed inside the elastic sheet.

The connection target member may be disposed outside the elastic sheet. Consequently, the elastic wiring member can be configured such that the connection target member is externally attached to the elastic sheet.

The reinforcing member may be disposed inside the elastic sheet. In this case, the reinforcing member can function as a reinforcement core for the elastic sheet and effectively inhibit, from the inside of the elastic sheet, the elastic sheet from stretching and contracting, or deforming around the connection part.

The reinforcing member may be exposed on a surface of the elastic sheet. Such a configuration can effectively inhibit the elastic sheet from stretching and contracting, or deforming around the connection part exposed on the surface of the elastic sheet.

The elastic sheet may include cushioning part interposed between the connection part and the reinforcing member. The stretchable cushioning part interposed between the connection part having stretchability and the reinforcing member having no stretchability can reduce stress that is generated in a boundary area between the stretchable wiring line and the reinforcing member when the elastic sheet stretches and contracts, or deforms. This can reduce the risk of break of the stretchable wiring line.

The elastic sheet may include a base sheet holding the stretchable wiring line and a cover member covering the stretchable wiring line held by the base sheet. Such a configuration enables the stretchable wiring line to be embedded in the elastic sheet. In addition, the cover member, which covers the stretchable wiring line held by the base sheet, can protect the stretchable wiring line embedded in the elastic sheet.

The stretchable wiring line is disposed on a flat surface of the base sheet and the flat surface faces the cover member. The flat surface of the base sheet facilitates formation of the stretchable wiring line.

The reinforcing member may have a sheet-like shape to extend in a direction along a surface of the elastic sheet. Such a configuration enables the reinforcing member, which is sheet-shaped, to be easily incorporated into the elastic wiring member if the elastic wiring member is thin, and also enables the reinforcing member to be easily integrated with the elastic sheet. In addition, the volume of the reinforcing member having such a shape is small in the elastic member. This enables the entire elastic wiring member to retain flexibility. In this case, the reinforcing member may be aligned with the connection part in a thickness direction of the elastic sheet. Since the sheet-shaped reinforcing member is disposed above or below the connection part in the thickness direction of the elastic sheet, the reinforcing member extending in the direction along the surface of the elastic sheet can inhibit the elastic sheet from stretching and contracting, or deforming around the connection part.

The reinforcing member may be disposed in contact with the connection part. Such a configuration can prevent the connection part from stretching and contracting.

The reinforcing member may have a sheet-like shape to extend in the direction along the surface of the elastic sheet and may be disposed adjacent to a side of the connection part so as to extend in a direction in which the elastic sheet stretches and contracts. In such a configuration, the reinforcing member can inhibit the connection part and part of the elastic sheet located adjacent to the side of the connection part from stretching and contracting, or deforming. If the stretchable wiring line is disposed on a flat surface of the base sheet and the flat surface faces the cover member, the connection part and the reinforcing member can be arranged in the same plane, so that the reinforcing member can also be disposed on the flat surface of the base sheet facing the cover member.

The reinforcing member may have a wall-like shape having a height in the thickness direction of the elastic sheet and may be disposed adjacent to a side of the connection part so as to extend in the direction in which the elastic sheet stretches and contracts. The reinforcing member having such a wall-like shape can inhibit the connection part and its surrounding part of the elastic wiring member, which is thick, from stretching and contracting, or deforming. Such a configuration can also protect the connection part when the elastic wiring member is used in applications where the elastic wiring member is repeatedly bent. Furthermore, the reinforcing member may be disposed so as to surround the periphery of the connection part while being located adjacent to sides of the periphery of the connection part. Such a configuration can make it difficult for the connection part and the periphery thereof to stretch and contract in any direction. This ensures that stretching and contracting, or deformation of the elastic sheet is reduced or eliminated.

The reinforcing member may have a block-like shape to cover the connection part. Such a configuration enables the entire connection part to be protected against stretching and contracting, or deformation of the elastic sheet.

The elastic sheet may be a band to be attached to a human body or a band to be attached to a device. Configuring the elastic sheet as a band to be attachable to a human body or a device enables the elastic wiring member to serve as an electronic device for use in applications involving deformation or movement, such as a wearable device and a robot.

The present invention can further provide an electronic device including the elastic wiring member having any of the above-described configurations according to the invention of the present application and an external electronic component electrically connected to the contact part of the elastic wiring member from outside of the elastic sheet. With such a configuration, the electronic device including a necessary external electronic component can be used in applications where bendability or stretchability is required.

### Advantageous Effects of Invention

The elastic wiring member according to the present invention reduces or eliminates stretching and contracting, or deformation of the connection part of the stretchable wiring line disposed in the elastic sheet and part of the elastic sheet surrounding the connection part. The elastic wiring member is accordingly less likely to undergo a change in resistance caused by stretching and contracting the connection part, thus reducing or eliminating the likelihood that, for example, an electronic component in electrical communication contact with the connection part may be separated from the connection part. Therefore, the elastic wiring member that is stretchable as a whole and that exhibits excellent conducting performance and excellent stability of connection to, for example, an electronic component, can be achieved.

Furthermore, incorporating such an elastic wiring member and an electronic component into an electronic device enables the electronic device to serve as a deformable or movable device, such as a wearable device or a joint of a robot.

### Brief Description of Drawings

[Fig. 1] Fig. 1 is a schematic plan view of an electronic device including an elastic wiring member according to a first embodiment.
[Fig. 2] Fig. 2 includes a longitudinal sectional view taken along line SA-SA in Fig. 1 and an enlarged view of part of a section.
[Fig. 3] Fig. 3 includes diagrams, corresponding to the enlarged view of the part in Fig. 2, explaining operation of cushioning part of a base sheet.
[Fig. 4] Fig. 4 is a plan view without an electronic component and a cover member in Fig. 1.
[Fig. 5] Fig. 5 includes a longitudinal sectional view taken along line SB-SB in Fig. 4 and an enlarged view of part of a section.
[Fig. 6] Fig. 6 is a plan view, corresponding to Fig. 4, of an elastic wiring member according to a second embodiment.
[Fig. 7] Fig. 7 includes a longitudinal sectional view taken along line SC-SC in Fig. 6 and an enlarged view of part of a section.
[Fig. 8] Fig. 8 includes a cross-sectional view taken along line SD-SD in Fig. 6 and an enlarged view of part of a section.
[Fig. 9] Fig. 9 is an enlarged plan view of essential part of an elastic wiring member according to a third embodiment.
[Fig. 10] Fig. 10 is a sectional view taken along line SE-SE in Fig. 9.
[Fig. 11] Fig. 11 is an enlarged plan view of essential part of an elastic wiring member according to a fourth embodiment.
[Fig. 12] Fig. 12 is a sectional view taken along line SF-SF in Fig. 11.
[Fig. 13] Fig. 13 is an enlarged plan view of essential part of an elastic wiring member according to a fifth embodiment.
[Fig. 14] Fig. 14 is a sectional view taken along line SG-SG in Fig. 13.
[Fig. 15] Fig. 15 is an enlarged plan view of essential part of an elastic wiring member according to a sixth embodiment.
[Fig. 16] Fig. 16 is a sectional view taken along line SH-SH in Fig. 13.

### Description of Embodiments

Embodiments of an elastic wiring member according to the present invention will be described. A redundant description of the same material, composition, manufacturing method, operation, advantageous effects, and so on in the embodiments will be omitted.

The elastic wiring member is used as a stretchable electronic component. Specifically, the elastic wiring member is used as an elastic circuit board including a circuit wiring line for mounting an electronic component, such as an electronic element, on a conductive line, a stretchable band for attaching a wearable device to a human body, or a movable joint of, for example, an industrial robot or a medical robot. The elastic wiring member includes a stretchable wiring line having stretchability and an elastic sheet, formed of a rubber-like elastic body, holding the stretchable wiring line.

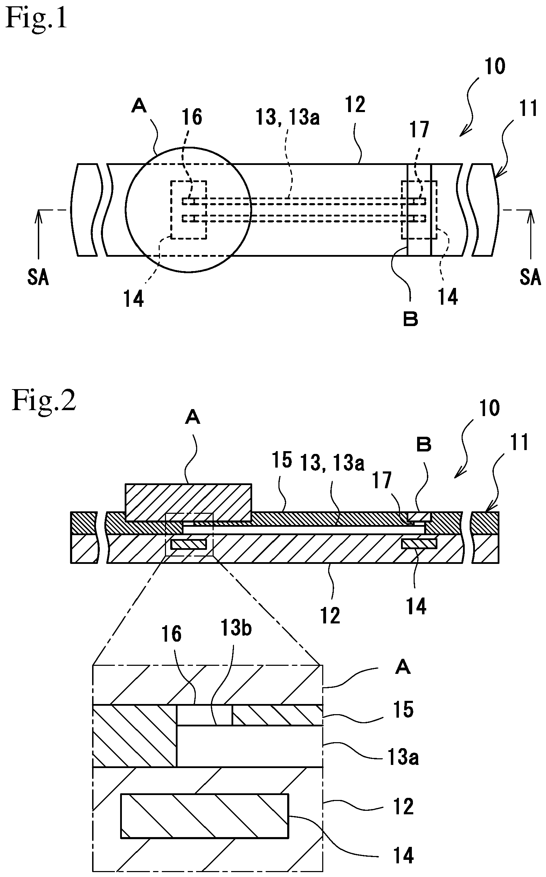

### First Embodiment: [Figs. 1 to 4]

Figs. 1 to 4 illustrate an elastic wiring member 11 according to a first embodiment. Fig. 1 is a schematic plan view illustrating an electronic device 10 including the elastic wiring member 11, an electronic device main body A, serving as a "connection target member", and an electronic component B, serving as a "connection target member". Fig. 2 includes sectional views of the device. For the electronic device main body A, for example, a watch main body of a digital watch can be used. For the electronic component B, for example, a light-emitting diode (LED) for illumination can be used. Examples of the "connection target member" are not limited to those examples.

As illustrated in Figs. 1 and 2, the electronic device 10 includes the elastic wiring member 11 including a base sheet 12, stretchable wiring lines 13 laminated on a surface of the base sheet 12, reinforcing members 14 arranged inside the base sheet 12, and a cover member 15 covering the surface of the base sheet 12, the electronic device main body A connected to the elastic wiring member 11 through contacts 16, and the electronic component B connected to the elastic wiring member 11 through contacts 17. The base sheet 12 and the cover member 15 constitute an "elastic sheet" in the elastic wiring member according to the present invention. Each of the contacts 16 and 17, the electronic device main body A, and the electronic component B serves as a "connection target member".

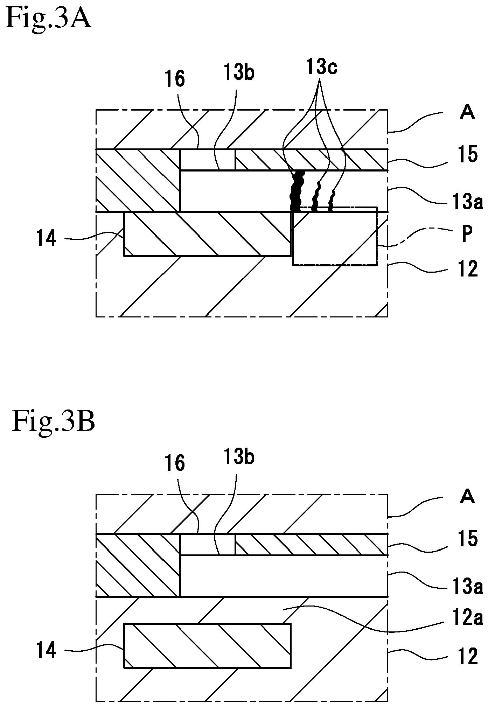

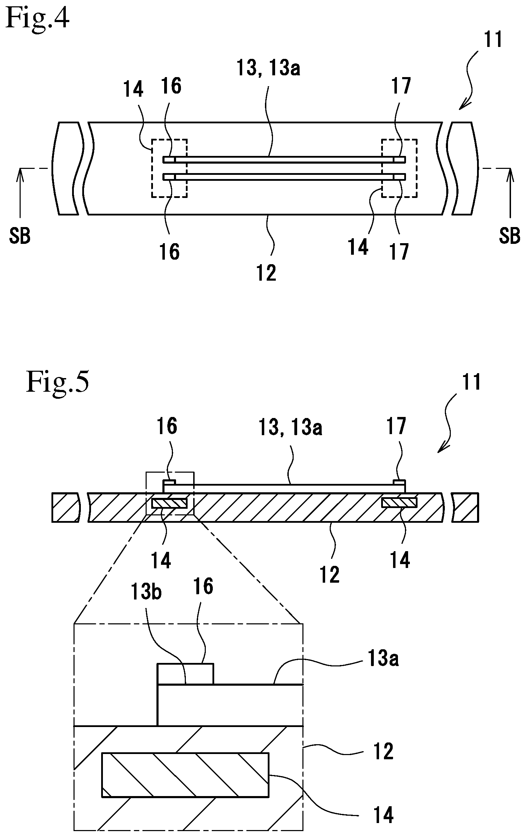

The components included in the elastic wiring member 11 will now be described. Figs. 3 and 4 illustrate the elastic wiring member 11 in a state where the cover member 15, the electronic device main body A, and the electronic component B are removed from the electronic device 10 (but the contacts remain) for convenience of explanation.

The base sheet 12 is a component that serves as a base of the elastic wiring member 11. If the elastic wiring member 11 is included in a watch type wearable device, the base sheet 12 and the cover member 15 can be included in a wrist band. The base sheet 12 is formed of a bendable, stretchable, rubber-like elastic body, especially a material required to be weatherproof and durable in practical use of the wearable device.

Examples of the material that can be used for the base sheet 12 include crosslinked rubbers, such as silicone rubber, natural rubber, isoprene rubber, butadiene rubber, acrylonitrile-butadiene rubber, 1,2-polybutadiene, styrene-butadiene rubber, chloroprene rubber, nitrile rubber, butyl rubber, ethylenepropylene rubber, chlorosulfonated polyethylene rubber, acrylic rubber, epichlorohydrin rubber, fluororubber, and urethane rubber, and thermoplastic elastomers, such as styrene-based thermoplastic elastomer, olefin-based thermoplastic elastomer, ester-based thermoplastic elastomer, urethane-based thermoplastic elastomer, amide-based thermoplastic elastomer, vinyl chloride-based thermoplastic elastomer, and fluorine-containing thermoplastic elastomer. Among these materials, silicone rubber is preferable in view of, for example, workability, weatherproofness, and compression set.

The base sheet 12 preferably has a hardness A, defined in Japanese Industrial Standards (JIS) K 6253, in the range of 30 to 80. A hardness less than A30 indicates that the base sheet 12 is too flexible and may be stretched to an extent to which the stretchable wiring line 13 is stretched beyond its elastic limit. A hardness greater than A80 indicates that the base sheet 12 is too hard and thus hardly stretches. The base sheet 12 having a hardness greater than A80 is not suitable for its intended purpose. More preferably, a soft material having a hardness in this preferable range is used because a human-friendly feel has recently been required.

Each of the stretchable wiring lines 13 includes a conductive line 13a and connection parts 13b located on the conductive line 13a. The stretchable wiring line 13 is required to be a low-resistance conductor. Since the stretchable wiring line 13 is intended to stretch and contract together with the stretchable base sheet 12, the stretchable wiring line 13 has to be made of a material that does not break by stretching and contracting. Specifically, it is preferred that the stretchable wiring line 13 be a stretchable, conductive coating film.

The conductive coating film includes a conductive filler mainly exhibiting conductivity and a matrix holding the conductive filler. For the conductive filler, conductive powder, such as carbon powder or metal powder, can be used. To form a wiring line for power or signal transmission, low-resistance metal powder is preferably used. Among metal powders, silver powder having a certain level of weatherproofness and an extremely low resistance is particularly preferable. The shape of the conductive filler is not particularly limited. For the conductive filler in the form of fibers, a relatively small amount of conductive filler fibers can contribute to achieving low resistance. For the conductive filler in the form of flakes, a relatively small amount of conductive filler flakes can contribute to reducing a change in resistivity caused by stretching and contracting as well as achieving low resistance. The conductive coating film preferably contains 15 to 50 percent by volume conductive filler. Less than 15 percent by volume indicates that the resistance may be excessively increased. Greater than 50 percent by volume indicates that the proportion of the matrix holding the conductive filler is too small, thus increasing the likelihood that the stretchable wiring line 13 may, for example, be cracked and broken when stretched.

The matrix can be made of a material identical with or similar to that for the above-described base sheet 12, because the use of the material identical with or similar to that for the base sheet 12 facilitates increase in degree of tight contact between the stretchable wiring line 13 and the base sheet 12. The material for the matrix is preferably more flexible than the material for the base sheet 12. The reason is as follows. The stretchable wiring line 13 contains a large amount of conductive filler. If the stretchable wiring line 13 has the same hardness as that of the base sheet 12, the stretchable wiring line 13 would be more difficult to stretch than the base sheet 12 as the stretchable wiring line 13 contains the large amount of conductive filler. Therefore, a more flexible material than the base sheet 12 can be used to make the stretchable wiring line 13, thus causing the stretchable wiring line 13 to have stretchability equal to or greater than that of the base sheet 12.

In other words, to cause the stretchable wiring line 13 to have such stretchability, the matrix is preferably more flexible than the base sheet 12 and has a hardness A in the range of A10 to A50. A hardness less than A10 indicates that the matrix is flexible but a low degree of crosslinking in the matrix reduces the strength of the matrix. The matrix having such a hardness tends to break. A hardness greater than A50 indicates poor stretchability. The matrix having such a hardness tends to break. The term "good stretchability" means either having low tensile stress or having high tensile elongation at break.

For the resistance of the stretchable wiring line 13, the stretchable wiring line 13 in an unstretched state preferably has a volume resistivity of 1.0×10⁻⁴ to 1.0×10⁻² Ω·cm. A volume resistivity less than 1.0×10⁻⁴ Ω·cm indicates that the amount of conductive filler is large and the proportion of the matrix in the stretchable wiring line 13 is relatively small. The stretchable wiring line 13 exhibiting such a volume resistivity tends to be cracked when stretched, for example. This increases the likelihood that the stretchable wiring line 13 may be broken. A volume resistivity greater than 1.0×10⁻² Ω·cm indicates that the stretchable wiring line 13 has too low conductivity and its application may be limited.

For the conductive powder, carbon is typically difficult to use because the use of carbon as conductive powder results in an increase in volume resistivity. However, the use of carbon leads to good weatherproofness. The stretchable wiring line 13 containing carbon has such an advantage and thus can be used in applications in spite of the fact that the carbon-containing wiring line has high resistivity. For example, the carbon-containing stretchable wiring line 13 can be used as a wiring line for a sensor that detects a change in resistance, a wiring line for body surface potential measurement, or a wiring line to be used while exposed to the outside. In this case, the stretchable wiring line 13 preferably has a volume resistivity of 100 Ω·cm or less.

In the stretchable wiring line 13, the conductive line 13a includes the connection parts 13b connecting to the contact 16 of the electronic device main body A and the contact 17 of the electronic component B. In other words, the conductive line 13a of the stretchable wiring line 13 is in conductive connection with the contact 16 of the electronic device main body A and the contact 17 of the electronic component B through the connection parts 13b. In Figs. 1 to 4, the connection part 13b is part of each stretchable wiring line 13 in contact with the contact 16 or the contact 17.

To firmly fix the stretchable wiring line 13 to a "connection target", such as the electronic device main body A or the electronic component B, a conductive adhesive or, for example, a metal layer for soldering or a carbon printed layer, can be disposed between the connection parts 13b and the contacts 16 and 17. Among these materials, the conductive adhesive is preferable in view of adhesiveness with the conductive coating film.

The reinforcing members 14 are embedded in the base sheet 12. Each reinforcing member 14 in the present embodiment, in plan view, is formed so as to have a greater area than each connection part 13b of the stretchable wiring line 13 connected to the contact 16 or 17 and cover the connection part 13b such that the reinforcing member 14 surrounds the connection part 13b. The term "surrounding the connection part" means that outer edges of the connection part 13b (in this case, a contact surface of the stretchable wiring line 13 in contact with the contact 16 or 17) are located within outer edges of the reinforcing member 14 when the base sheet 12 is viewed from above, or in plan view.

The significance of the reinforcing member 14 will now be described. Each connection part 13b of the stretchable wiring line 13 is a part of the stretchable wiring line 13. When the stretchable wiring line 13 stretches and contracts, the connection part 13b stretches and contracts accordingly. Each of the contact 16 of the electronic device main body A and the contact 17 of the electronic component B is formed of a piece of metal and is rigid. When the stretchable wiring line 13 stretches and contracts, stress is concentrated at the interface between the connection part 13b and each of the contacts 16 and 17. Consequently, stretching of the connection part 13b of the stretchable wiring line 13 may cause the stretchable wiring line 13 to be broken or separated from the contact 16 or 17. As a countermeasure against such a problem, the reinforcing member 14 is disposed in order to reduce deformation of the connection part 13b.

When the elastic wiring member 11 is stretched by an external force, the base sheet 12 and the wiring member 13 are also stretched simultaneously. At this time, each reinforcing member 14, which is rigid, inhibits the base sheet 12 and the stretchable wiring lines 13 from stretching in proximity to the reinforcing member 14. More specifically, when the elastic wiring member 11 stretches, the reinforcing member 14 hardly stretches in a direction along a surface of the elastic wiring member (or a direction orthogonal to a thickness direction of the elastic wiring member), thus inhibiting stretching of part of the base sheet 12 and parts of the stretchable wiring lines 13 surrounded by the reinforcing member 14 in plan view. Therefore, the connection parts 13b surrounded by the parts inhibited from stretching are also inhibited from stretching.

For this reason, the reinforcing member 14 that is more rigid than the base sheet 12 is used. More specifically, the reinforcing member 14 is preferably more rigid than the base sheet 12 by 20 points or more in terms of hardness A. The reinforcing member 14 can be formed by using the same material as that for the above-described base sheet 12 and adjusting the material such that the reinforcing member 14 is more rigid than the base sheet 12 or can be formed of another rubber-like elastic body similarly adjusted rigidly or a rigid resin. Preferably usable examples of the rubber-like elastic body adjusted in hardness include silicone rubber and urethane rubber.

Preferable examples of the rigid resin include thermoplastic resin and thermosetting resin that are excellent in, for example, mechanical strength, heat resistance, durability, and reliability. Examples of the thermoplastic resin include polypropylene resin, polyethylene resin, polyvinyl chloride resin, polystyrene resin, acrylonitrile-styrene acrylate resin, acrylonitrile butadiene styrene resin, polyamide resin, polyacetal resin, polycarbonate resin, polyethylene terephthalate resin, polybutylene terephthalate resin, polyphenylene oxide resin, polyphenylene ether resin, polyphenylene sulfide resin, polyurethane resin, liquid crystal polymer, and a composite resin of such resins. Examples of the thermosetting resin include epoxy resin and urethane resin.

The cover member 15 is a member that is formed in order to protect the stretchable wiring lines 13 and that covers at least the stretchable wiring lines 13. The cover member 15 can be made of a material selected from the above-described materials for the base sheet 12. The same material as that for the base sheet 12 may be used or materials different from that for the base sheet 12 may be used in combination.

### <Production>:

To produce the elastic wiring member 11, the reinforcing members 14, made of rigid resin, are first fabricated by injection molding. Subsequently, the reinforcing members 14 are placed in a mold to mold the rubber-like elastic body for the base sheet 12 integrally with the reinforcing members 14, thus forming the base sheet 12.

The base sheet 12 is coated with a conductive paste, thus forming the stretchable wiring lines 13, which are formed of a conductive coating film. The connection parts 13b, serving as one ends, of the stretchable wiring lines 13 are fixed to the contacts 16 of the electronic device main body A by a conductive adhesive. The connection parts 13b, serving as the other ends, of the stretchable wiring lines 13 are fixed to the contacts 17 of the electronic component B by the conductive adhesive. The resultant product is placed in a mold to mold a rubber-like elastic body, serving as the cover member 15, integrally with the product. Integrally molding the base sheet 12 with the cover member 15 enables production of the elastic wiring member 11 that includes therein the stretchable wiring lines 13 and the reinforcing members 14 and further includes the electronic device main body A and the electronic component B. The base sheet 12 and the cover member 15 can be made of the same material, for example, silicone rubber. Consequently, these components can constitute an "elastic sheet", serving as an integrally-molded, one-piece structure.

### <Operation and Advantageous Effects>:

The elastic wiring member 11 is configured such that the stretchable wiring lines 13 are arranged in the "elastic sheet" including the base sheet 12 and the cover member 15. The elastic wiring member 11 as a whole is stretchable or deformable. In the base sheet 12, the reinforcing members 14 are embedded adjacent to the connection parts 13b. Therefore, if the elastic wiring member 11 is stretched to twice its original length (at 200 percent extension) in its longitudinal direction, parts of the elastic wiring member 11 in proximity to the reinforcing members 14, particularly cushioning parts 12a of the rubber-like elastic body located between the reinforcing members 14 and the contacts 16 and 17 are inhibited from stretching. Consequently, the stretchable wiring lines 13 arranged on the surface of the rubber-like elastic body are also inhibited from stretching, thereby reducing or eliminating deformation of the connection parts 13b. This prevents a break in the conductive lines 13a, separation of the connection parts 13b from the contacts 16 and 17, and excessive stretching of the connection parts 13b, thus achieving stability in resistance.

The base sheet 12 includes the above-described cushioning parts 12a. Fig. 3(a) illustrates an example of the reinforcing member 14 in contact with the stretchable wiring line 13 without the cushioning part 12a therebetween. In such a configuration, when the base sheet 12 is stretched, stress is concentrated in an interface area P extending from the interface between the base sheet 12 and the reinforcing member 14. The presence of such an interface area results in a reduction in durability of the stretchable wiring line 13. Repeated use may cause interface separation and breaks 13c in the stretchable wiring line 13. In contrast, as illustrated in Fig. 3(b), the cushioning part 12a is provided such that the stretchable wiring line 13 is not directly on the interface area P in the base sheet 12. This arrangement enables stress that is generated in the interface area P when the base sheet 12 is stretched to be reduced by stretching the cushioning part 12a, thus reducing the above-described risk of breaks.

### <Modification>:

Although the present embodiment has been described with respect to the example in which the base sheet 12 is formed as a thin sheet-like band, the shape of the base sheet 12 may have any shape suitable for an application. Furthermore, a "connection target member" connected to the elastic wiring member 11 can be used in accordance with an application or function to be achieved. Examples of the electronic device main body A include a heart rate meter. Examples of the electronic component B include components, such as a switch, a connector, an antenna, a liquid crystal display (LCD), an LED, a microphone, a speaker, a battery, and a sensor, an integrated circuit (IC), and circuit elements, such as a resistor, a capacitor, and a coil. Furthermore, for the contacts 16 included in the electronic device main body A and the contacts 17 included in the electronic component B illustrated in the present embodiment, conductive contact members, such as pieces of metal, corresponding to the contacts 16 and 17 may be included in the connection parts 13b of the stretchable wiring lines 13.

Although the present embodiment illustrates the configuration in which one end of the conductive line 13a of each stretchable wiring line 13 is connected to the electronic device main body A and the other end thereof is connected to the electronic component B, the position of each connection part 13b is not limited to the end of the conductive line 13a. Each of the electronic device main body A and the electronic component B can be connected to any part of the stretchable wiring line 13. Furthermore, any number of connection parts 13b can be arranged.

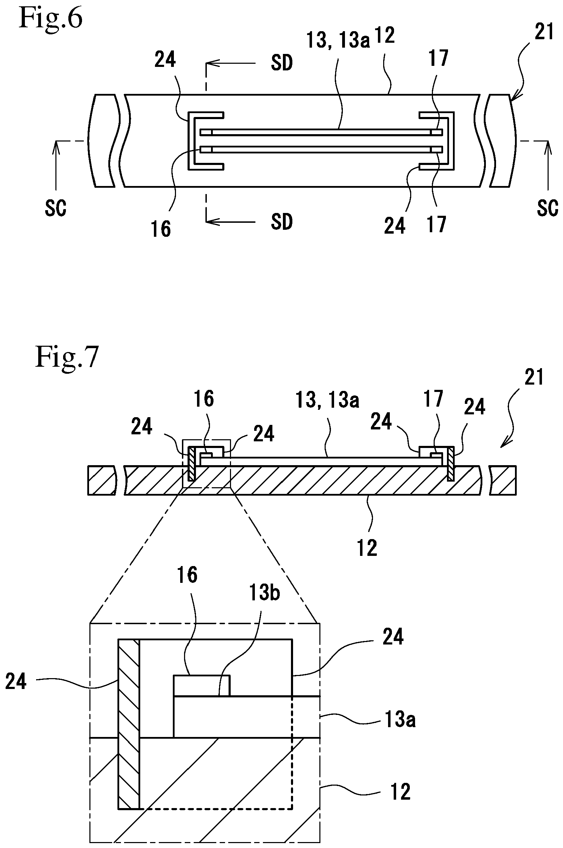

### Second Embodiment: [Figs. 6 to 8]

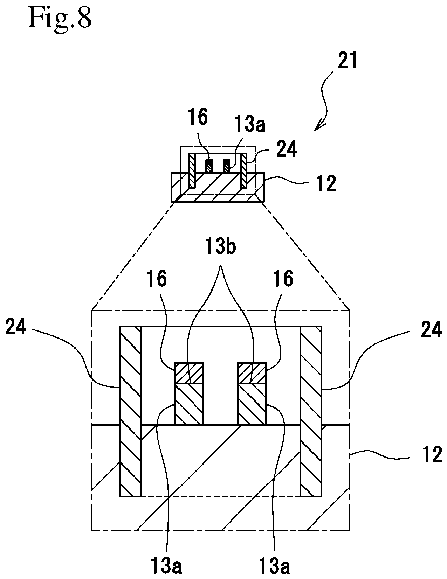

An elastic wiring member 21 according to a second embodiment will now be described. Fig. 6 is a schematic plan view, corresponding to Fig. 4, of the elastic wiring member 21. Fig. 7 includes sectional views of the member of Fig. 6. Fig. 8 includes cross-sectional views of the member divided in the lateral direction of the base sheet 12 into two segments. An electronic component connected to the elastic wiring member 21 and the cover member 15 are not illustrated in Figs. 6 to 8.

The elastic wiring member 21 differs from the elastic wiring member 11 according to the first embodiment in the position and shape of a reinforcing member 24. As illustrated in Fig. 6, the elastic wiring member 21 includes reinforcing members 24 such that each reinforcing member 24 surrounds at least three outer edges of connection part 13b of each stretchable wiring line 13, or has a U-shape when the base sheet 12 is viewed from above, or in plan view. As illustrated in Fig. 7, the reinforcing member 24 is disposed in an upright position such that a thickness direction of the reinforcing member 24 is orthogonal to a thickness direction of the base sheet 12. In other words, the reinforcing member 24 has a wall-like shape having a height in a thickness direction of the "elastic sheet" including the base sheet 12 and the cover member 15. The reinforcing member 24 is disposed adjacent to the sides of the connection part 13b so as to inhibit the "elastic sheet" from stretching and contracting. When the reinforcing member 24 is viewed from the connection part 13b connected to the contact 16 or 17, the reinforcing member 24 is disposed at a location obtained by outwardly extending the connection part 13b on the surface of the base sheet 12, or disposed so as to surround the three sides of the periphery of the connection part 13b.

When the elastic wiring member 21 is stretched by an external force, the base sheet 12 and the stretchable wiring lines 13 are also stretched simultaneously. At this time, each reinforcing member 24 inhibits the base sheet 12 and the stretchable wiring lines 13 from stretching in proximity to the reinforcing member 24. More specifically, when the elastic wiring member 21 stretches, the reinforcing member 24 hardly stretches in a direction along a surface of the elastic wiring member (or a direction orthogonal to a thickness direction of the elastic wiring member), thus inhibiting stretching of part of the base sheet 12 and parts of the stretchable wiring lines 13 surrounded by the reinforcing member 24. Therefore, the connection parts 13b included in the parts inhibited from stretching are also inhibited from stretching.

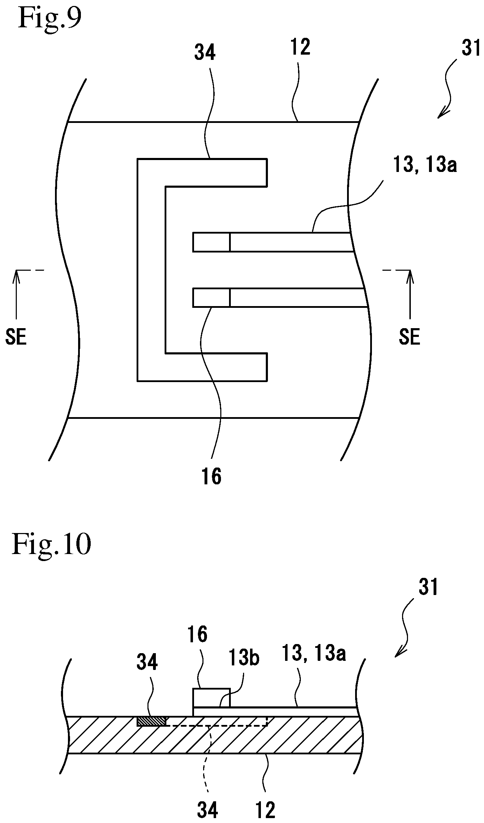

### Third Embodiment: [Figs. 9 and 10]

Fig. 9, which illustrates an elastic wiring member 31 according to a third embodiment, is an enlarged plan view of part of the elastic wiring member 31 in proximity to the contacts 16. Fig. 10 is a sectional view of the part. In Figs. 9 and 10, an electronic component connected to the elastic wiring member and the cover member 15 are not illustrated.

The elastic wiring member 31 according to the present embodiment also differs from the elastic wiring members 11 and 21 according to the other embodiments in the shape of a reinforcing member 34. Referring to Fig. 9, the reinforcing member 34 has a shape similar to that of the stretchable wiring line 24 at first glance because the reinforcing member 34 is also U-shaped in plan view. The stretchable wiring line 34 differs from the stretchable wiring line 24 as follows: the stretchable wiring line 24 includes three flat reinforcing member parts in an upright position arranged in a U-shaped pattern, whereas the stretchable wiring line 34 according to the present embodiment is a flat, U-shaped stamped reinforcing member disposed on the base sheet 12.

The reinforcing member 34 has a film-like shape. As illustrated in Fig. 10, the reinforcing member 34 is disposed flush with the base sheet 12. This arrangement enables the reinforcing member 34 to be molded integrally with the base sheet 12, thus resulting in a reduction in production cost.

When the elastic wiring member 31 is stretched by an external force, the base sheet 12 and the stretchable wiring lines 13 are also stretched simultaneously. At this time, the reinforcing member 34 inhibits the base sheet 12 and the stretchable wiring lines 13 from stretching in proximity to the reinforcing member 34. More specifically, when the elastic wiring member 31 stretches, the reinforcing member 34 hardly stretches in a direction along a surface of the elastic wiring member (or a direction orthogonal to a thickness direction of the elastic wiring member), thus inhibiting stretching of part of the base sheet 12 and parts of the stretchable wiring lines 13 surrounded by the reinforcing member 24 having a U-shape in plan view. Therefore, the connection parts 13b included in the parts inhibited from stretching are also inhibited from stretching.

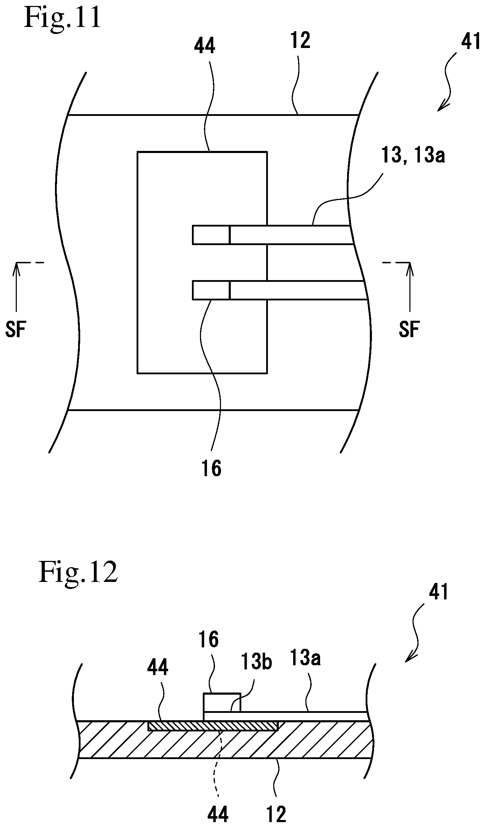

### Fourth Embodiment: [Figs. 11 and 12]

Fig. 11 is a plan view, corresponding to Fig. 9, of an elastic wiring member 41. Fig. 12 is a sectional view of the member of Fig. 11. The elastic wiring member 41 according to the present embodiment includes a reinforcing member 44, which has the same shape as that of the reinforcing member of the elastic wiring member 11 according to the first embodiment. The elastic wiring member 41 differs from the elastic wiring member 11 according to the first embodiment as follows: the reinforcing member of the elastic wiring member 11 according to the first embodiment is disposed inside the base sheet 12, whereas the reinforcing member 44 is disposed in the surface of the base sheet 12.

When the elastic wiring member 41 is stretched by an external force, the reinforcing member 44 hardly stretches and thus inhibits part of the base sheet 12 and parts of the stretchable wiring lines 13 in contact with the reinforcing member 44 from stretching. Since the connection parts 13b in the present embodiment are arranged on the reinforcing member 44, the connection parts 13b are also inhibited from stretching.

However, stress may be concentrated at end part of the reinforcing member 45. Since the stretchable wiring lines 13 may be broken at the interface between the reinforcing member 45 and the base sheet 12, caution is required. For this reason, the surface of at least part of each stretchable wiring line 13 located in an interface area extending from the interface between the reinforcing member 45 and the stretchable wiring line 13 is covered with the cover member 15 such that the part is reinforced by the cover member 15 located on the opposite side of the reinforcing member from the base sheet 12.

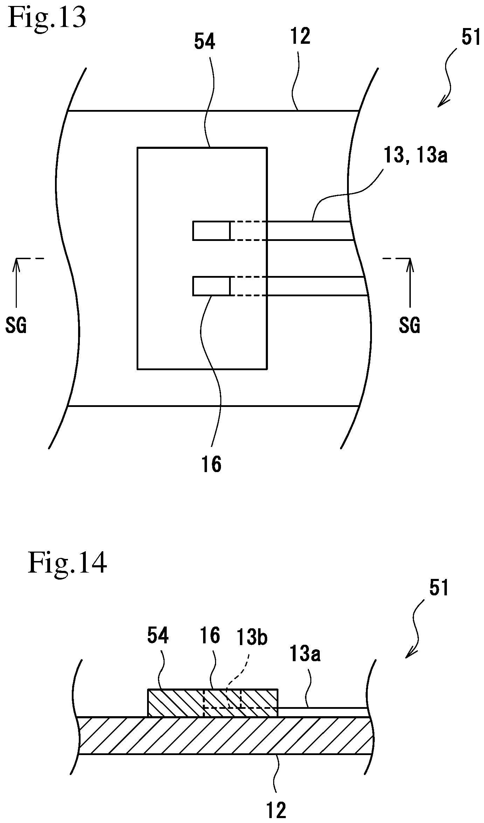

### Fifth Embodiment: [Figs. 13 and 14]

Fig. 13 is a plan view, corresponding to Fig. 9, of an elastic wiring member 51. Fig. 14 is a sectional view of the member of Fig. 11. As illustrated in Fig. 14, the elastic wiring member 51 according to the present embodiment includes a massive and block-shaped reinforcing member 54 in the base sheet 12. The reinforcing member 54 has a shape in which the reinforcing member 54 protrudes from the base sheet 12 in the thickness direction of the base sheet 12. The reinforcing member 54 exposes the surfaces of the contacts 16 and is provided in the base sheet 12 such that the reinforcing member 54 covers parts of the contacts 16 other than the surfaces thereof. The reinforcing member 54 having such a shape can be formed by disposing the contacts 16 of the electronic device main body A on the stretchable wiring lines 13, potting or applying liquid resin to the periphery of the electronic device main body A, and curing the liquid resin.

When the elastic wiring member 51 according to the present embodiment is stretched, the reinforcing member 54 is inhibited from stretching. Thus, the connection parts 13b of the stretchable wiring lines 13 surrounded by the reinforcing member 54 are also inhibited from stretching.

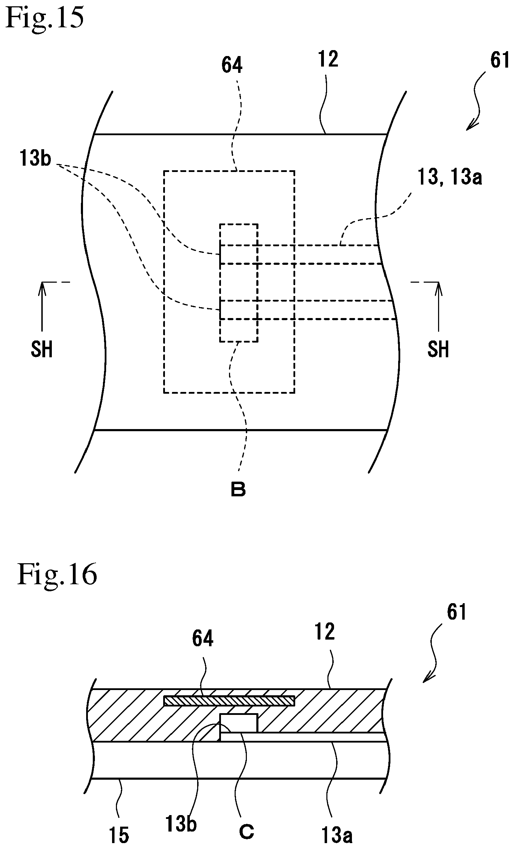

### Sixth Embodiment: [Figs. 15 and 16]

Fig. 15 is a plan view, corresponding to Fig. 9, of an elastic wiring member 61. Fig. 16 is a sectional view of the member of Fig. 15. As illustrated in Fig. 15, the elastic wiring member 61 according to the present embodiment includes a film-shaped reinforcing member 64 disposed in the base sheet 12 and located above an electronic component C in the base sheet 12. Such an elastic wiring member 61 can be formed by arranging the stretchable wiring lines 13 on the cover member 15, connecting the electronic component C to the connection parts 13b of the wiring lines, and covering the electronic component C and so on with the base sheet 12 including the reinforcing member 64.

When the elastic wiring member 61 according to the present embodiment is stretched, the reinforcing member 64 is inhibited from stretching. Thus, the connection parts 13b of the stretchable wiring lines 13 surrounded by the reinforcing member 64 are also inhibited from stretching.

The above-described embodiments are illustrative examples of the present invention. For example, the embodiments can be modified or changed, some of the elements in the embodiments can be eliminated, known techniques in the art can be added to the embodiments, and the embodiments can be combined without departing from the spirit and scope of the present invention. Such techniques are also within the scope of the present invention.

For the cushioning parts 12a of the base sheet 12 located between the reinforcing members and the connection parts 13b of the stretchable wiring lines, for example, parts made of a material different from that for the base sheet 12 or a material having different hardness from that of the base sheet 12 can be substituted for the cushioning parts 12a.

Although the arrangement of the reinforcing members 14 in the base sheet 12 is illustrated in the above-described embodiment, the reinforcing members 14 may be arranged not in the base sheet 12 but in the cover member 15 or may be arranged in both the base sheet 12 and the cover member 15.

The configuration formed by disposing the cover member 15 on the base sheet 12 before connection of the electronic component and the electronic device is illustrated in some of the above-described embodiments. For example, the electronic component A may be connected to the connection parts 13b of the base sheet 12 and, after that, the cover member 15 may be provided so as to cover the electronic component A.

The reinforcing member 14 may include a decorative portion that is exposed on the surface of the elastic wiring member and appears on the exterior of the elastic wiring member.

### Reference Signs List

- 10: electronic device
- 11, 21, 31, 41, 51, 61: elastic wiring member
- 12: base sheet (elastic sheet)
- 12a: cushioning part
- 13: stretchable wiring line
- 13a: conductive line
- 13b: connection part
- 13c: separation or break
- 14, 24, 34, 44, 54, 64: reinforcing member
- 15: cover member (elastic sheet)
- 16, 17: contact
- A: electronic device main body
- B, C: electronic component

## Claims

1. An elastic wiring member comprising:
an elastic sheet formed of a rubber-like elastic body;
a stretchable wiring line including a conductive line disposed inside the elastic sheet and connection part located on the conductive line; and
a reinforcing member disposed adjacent to the connection part and made of a rigid material, the reinforcing member inhibiting the elastic sheet from stretching and contracting, or deforming around the connection part.

2. The elastic wiring member according to Claim 1, further comprising:
a connection target member in electrical communication with the stretchable wiring line through the connection part.

3. The elastic wiring member according to Claim 1, wherein the stretchable wiring line includes a plurality of connection parts.

4. The elastic wiring member according to Claim 2 or 3, wherein the connection target member is at least one of an electronic device, an electronic component, and a contact member.

5. The elastic wiring member according to any one of Claims 2 to 4, wherein the connection target member is fixed to the connection part.

6. The elastic wiring member according to any one of Claims 1 to 5, wherein the connection target member is disposed inside the elastic sheet.

7. The elastic wiring member according to any one of Claims 1 to 6, wherein the reinforcing member is disposed inside the elastic sheet.

8. The elastic wiring member according to any one of Claims 1 to 7, wherein the reinforcing member is exposed on a surface of the elastic sheet.

9. The elastic wiring member according to any one of Claims 1 to 8, wherein the elastic sheet includes cushioning part interposed between the connection part and the reinforcing member.

10. The elastic wiring member according to any one of Claims 1 to 9, wherein the elastic sheet includes:
a base sheet holding the stretchable wiring line; and
a cover member covering the stretchable wiring line held by the base sheet.

11. The elastic wiring member according to any one of Claims 1 to 10,
wherein the reinforcing member has a sheet-like shape to extend in a direction along a surface of the elastic sheet, and
wherein the reinforcing member is aligned with the connection part in a thickness direction of the elastic sheet.

12. The elastic wiring member according to any one of Claims 1 to 10,
wherein the reinforcing member has a sheet-like shape to extend in a direction along a surface of the elastic sheet, and
wherein the reinforcing member is disposed adjacent to a side of the connection part so as to extend in a direction in which the elastic sheet stretches and contracts.

13. The elastic wiring member according to any one of Claims 1 to 10,
wherein the reinforcing member has a wall-like shape having a height in a thickness direction of the elastic sheet, and
wherein the reinforcing member is disposed adjacent to a side of the connection part so as to extend in a direction in which the elastic sheet stretches and contracts.

14. The elastic wiring member according to any one of Claims 1 to 10, wherein the reinforcing member has a block-like shape to cover the connection part.

15. The elastic wiring member according to any one of Claims 1 to 14, wherein the elastic sheet is a band to be attached to a human body or a band to be attached to a device.
